# EUROPEAN PATENT SPECIFICATION

(11) **EP 3 237 992 B1**
(45) Date of publication and mention of the grant of the patent: **21.10.2020**
(21) Application number: 15886646.7
(22) Date of filing: 24.03.2015
(51) Int. Cl.: G06F 1/20, H05K 7/20

(54) **LIQUID COOLING WITH A COOLING CHAMBER**
FLÜSSIGKEITSKÜHLUNG MIT EINER KÜHLKAMMER
REFROIDISSEMENT PAR LIQUIDE À L'AIDE D'UNE CHAMBRE DE REFROIDISSEMENT

(43) Date of publication of application: 01.11.2017
(73) Proprietor: Hewlett Packard Enterprise Development LP, Houston, TX 77070 (US)
(72) Inventor: FRANZ, John P., Houston, Texas 77070 (US); CADER, Tahir, Houston, Texas 77070 (US); NORTON, William K., Houston, Texas 77070 (US)
(74) Representative: Iqbal, Md Mash-Hud
(86) International application number: PCT/US2015/022246
(87) International publication number: WO 2016/153488

(56) References cited:
- US-A1- 2005 217 829
- US-A1- 2008 024 980
- US-A1- 2008 024 980
- US-A1- 2009 218 078
- US-A1- 2010 128 431
- US-A1- 2011 286 175
- US-A1- 2012 113 586
- US-A1- 2012 147 553
- US-A1- 2014 002 980

## Description

### Background

Electronic devices may have temperature limitations. For example, an electronic device may malfunction if the temperature of the electronic device reaches or exceeds a threshold temperature. Heat from the use of the electronic devices may be controlled using cooling systems. Example cooling systems include air and liquid cooling systems. US2008/0024980 discloses a liquid cooling unit. US2014/0002980 discloses a server memory cooling apparatus. US2009/0218078 discloses a computer cooling system. US2012/147553 discloses a liquid cooling system for a server.

### Brief Description of the Drawings

Figure 1 illustrates an example system for liquid cooling consistent with the present disclosure.
Figure 2 illustrates a diagram of an example of a comb structure for liquid cooling consistent with the present disclosure.
Figure 3 illustrates a diagram of an example system for liquid cooling according to the present disclosure.
Figure 4 further illustrates a diagram of an example system for liquid cooling according to the present disclosure.

### Detailed Description

Electronic systems may be designed to balance conflicts between power density, spatial layout, temperature requirements, acoustic noise, and other factors. Air cooling systems may use heat sinks and fans to remove "waste" heat from heat generating devices and/or a server system including the heat generating devices. As used herein, a heat generating device refers to electrical components found in a computing device such as a server, notebook computer, desktop computer, among other devices, which are capable of generating heat during operation. Examples of heat generating devices includes processors, such as central processing units (CPUs) and graphics processing units (GPUs), memory modules such as Dual In-line Memory Modules (DIMMs), and voltage regulators, among other devices. As used herein, a server system may refer to a system that may contain a plurality of servers and/or chassis stacked one above one another. A server may refer to a rack server, a blade server, a server cartridge, a chassis, a rack, and/or individual loads. A rack server may include a computer that is used as a server and designed to be installed in a rack. A blade server may include a thin, modular electronic circuit board that is housed in a chassis and each blade is a server. A server cartridge, as used herein, may include a frame (e.g., a case) substantially surrounding a processor, a memory, and a non-volatile storage device coupled to the processor. A chassis may include an enclosure which may contain multiple blade servers and provide services such as power, cooling, networking, and various interconnects and management.

The use of heat sinks and fans increase the electrical power to operate the heat generating device and/or server system, and may cause excessive acoustic noise and lower system density. Liquid cooling may be more efficient than air cooling; however, liquid cooling typically includes plumbing connections within the heat generating devices. As the liquid goes through the plumbing connections, the risk of leakage of the liquid within the heat generating device is introduced.

Liquid leakage may cause damage to the heat generating devices. For example, liquid leaked may cause a heat generating device to malfunction and/or terminate. To reduce damage, a dielectric fluid may be used. However, dielectric fluids are expensive compared to other liquids, are hazardous (e.g., safety issues in handling and limitation in how to dispose of the liquid), and their thermal performance is lower than other liquids, such as water.

A liquid cooling assembly may be used to direct a liquid coolant near but not in contact with the heat generating device. This technique is known as Direct Liquid Cooling (DLC) where the liquid coolant stays contained within tubes, hoses and/or manifolds and is transported as needed throughout the server system. In comparison, immersion cooling allows the liquid coolant to directly contact the heat generating devices. As used herein, a liquid coolant may refer to water, although liquids other than water may be used. The liquid cooling assembly may include a liquid cooling chamber and a liquid circulation loop, among other structures within the server, to carry the liquid coolant near the heat generating devices. In some examples, the liquid cooling assembly may be coupled to a wall structure with a plurality of liquid quick disconnects. The wall structure can be filled with a number of fluid channels that allow liquid coolant to be pumped in and out from a cooling base. Some sections of the liquid cooling assembly may not be in direct contact with the heat generating device yet through conducive structures enable the heat to transfer to the liquid cooling structure.

In some instances, a customer and/or other personnel may want to remove a liquid cooling assembly to service heat generating devices adjacent to the liquid cooling assembly. However, the liquid cooling assembly may be fixed in position, and may extend in a plurality of directions and small spaces within the server system, which may make it difficult to remove the liquid cooling assembly. For example, a customer may have a variety of heat generating devices installed in a server system. One of the heat generating devices may require service and/or replacement, and the customer may want to access the heat generating device quickly and efficiently, without risk of liquid leakage in the server system.

Examples in accordance with the present disclosure may include a liquid cooling system with an integrated liquid cooling chamber that may extend the flow of a liquid coolant near heat generating devices within a server system to cool the heat generating devices and allow for easy removal and service by a user, such as a customer. The liquid cooling system may direct heat from the heat generating device into the liquid coolant with a minimum amount of hoses and connections. Further, the liquid cooling system can simultaneously (e.g., substantially simultaneously) cool a plurality of devices within a server, such as a processor, memory modules, and a voltage regulator (VR), while reducing space consumption, and risk of liquid leakage. Further, the liquid cooling system can increase ease of access to access heat generating devices.

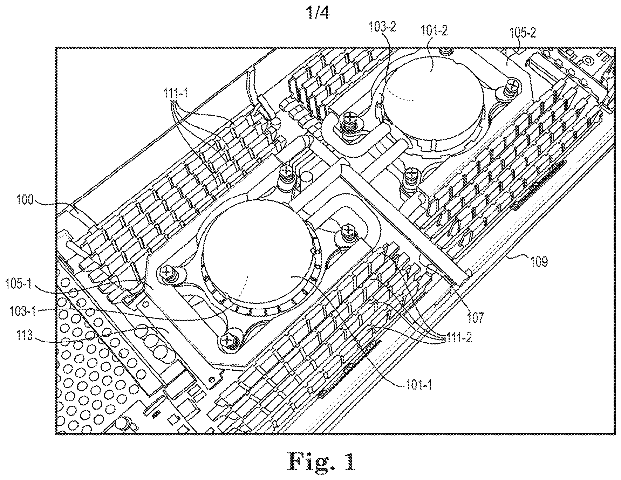

Figure 1 illustrates a system 100 for liquid cooling consistent with the present disclosure. The system 100 may include a liquid cooling chamber 101-1, 101-2 in contact with a heat generating device 103-1, 103-2 within a server system 109. While Figure 1 illustrates the liquid cooling chambers 101-1, 101-2 as having a circular shape, examples are not so limited and the liquid cooling chambers 101-1, 101-2 may have different shapes, such as square, rectangular, tubular, etc. Also, as used herein, a liquid cooling chamber may refer to a device to contain a liquid coolant and transfer heat from a heat generating device. The liquid coolant is not permanently stored in the liquid cooling chamber, rather, the liquid coolant is pumped and/or flows into and out of the liquid cooling chamber from a device external to the server. As used herein, to "transfer" heat may refer to the transfer of heat energy from a region of higher temperature to a region of lower temperature (e.g., lower relative to the higher temperature) by conduction and/or convection, among other heat transfer means.

In some examples, the liquid cooling chambers 101-1 and 101-2 (herein referred to collectively as liquid cooling chamber 101) may transfer heat into a liquid circulation loop 105-1 and 105-2 (herein referred to collectively as liquid circulation loop 105) extending around a perimeter of the liquid cooling chamber 101. As illustrated in Figure 1, the liquid circulation loop 105 can be adjacent to the liquid cooling chamber 101. For instance, the liquid circulation loop 105 can be located within a threshold distance from the liquid cooling chamber 101. The liquid circulation loop 105 may refer to a channel and/or plurality of channels that may direct the flow of liquid coolant. For example, the liquid circulation loop 105 may receive liquid coolant from a server cooling assembly associated with the server system 109, which may or may not be connected to a cooling base, as discussed herein. The liquid circulation loop 105 may receive the liquid coolant from the server cooling assembly, direct the flow of the liquid coolant into the liquid cooling chamber 101 for temporary storage and cooling of heat generating devices (e.g., heat generating device 103), and direct the flow of the liquid coolant through channels extending around the perimeter of the liquid cooling chamber 101.

The shape and/or design of the liquid circulation loop 105 is not limited to the shapes and/or design illustrated in Figure 1. For example, the liquid circulation loop 105 may have a square shape and/or design, as well as a curved shape and/or design. Additionally, the liquid circulation loop 105 may include portions having different shapes and/or designs. For instance, a first portion of the liquid circulation loop 105 may have a generally square shape, and a second portion of the liquid circulation loop 105 may have a generally curved shape.

In some examples, a liquid exit pipe 107 may be coupled to the liquid circulation loop 105 to direct a flow of the liquid coolant. The liquid exit pipe 107 may be coupled to the server cooling assembly, such as a water wall, that provides liquid coolant to a server rack. For example, the heat generating device 103 may be located in a server within the server system 109, and may further include the liquid exit pipe 107 to direct the flow of the liquid coolant to a location different than the liquid cooling chamber and the liquid circulation loop. For instance, in some examples, the liquid exit pipe 107 can direct the flow of the liquid coolant to a location external to the server, such as a cooling bay of the water wall structure. Put another way, each server within the server system 109 may include at least a liquid cooling chamber 101, a liquid circulation loop 105, a liquid exit pipe 107, and various heat generating devices 103, such that heat from the heat generating devices 103 is directed to a location external to the server, such as a cooling bay. However, examples are not so limited. The liquid exit pipe 107 can direct the flow of the liquid coolant to a location within the server. For instance, the liquid exit pipe 107 may direct the flow of the liquid coolant to a liquid-to-air heat exchanger (not shown in Figure 1) within the server to reject the heat from the heat generating devices 103 to ambient air in the server.

In some examples, the system 100 may include a plurality of heat generating devices 103, and the liquid circulation loop 105 may be arranged in various parallel or series flow paths for various routing or cooling requirements. For instance, the system 100 may include two processors, 103-1 and 103-2, among other heat generating devices. Each processor may have an associated liquid cooling chamber, such that processor 103-1 may be associated with liquid cooling chamber 101-1 and processor 103-2 may be associated with liquid cooling chamber 101-2. The liquid circulation loop 105 may be arranged in a serial flow arrangement such that liquid coolant may flow to liquid cooling chamber 101-1, around liquid cooling chamber 101-1 via liquid circulation loop 105-1, to liquid cooling chamber 101-2 via the liquid circulation loop 105-1 and/or liquid circulation loop 105-2, around liquid cooling chamber 101-2 via the liquid circulation loop 105-2, and exit the server via liquid exit pipe 107. Additionally and/or alternatively, the liquid circulation loop 105 may be arranged in a parallel flow arrangement such that liquid coolant may flow to liquid cooling chamber 101-1 and liquid cooling chamber 101-2 in parallel (e.g., substantially simultaneously), and the liquid coolant may flow around the liquid cooling chambers 101-1 and 101-2 via liquid circulation loops 105-1 and 105-2 in parallel (e.g., substantially simultaneously).

The liquid circulation loop 105 may be comprised of a thermally conductive material. For instance, the liquid circulation loop 105 may be comprised of aluminum, aluminum compositions, copper, copper compositions, platinum, platinum compositions, and/or other thermally conductive materials. In some examples, the liquid circulation loop 105 may have portions comprising different materials. For instance, a first portion of the liquid circulation loop 105 may be comprised of a thermally conductive material, such as aluminum, and a second portion of the liquid circulation loop 105 may be comprised of a material having a low thermal conductivity, such as plastic. In some examples, the liquid circulation loop 105 may be a hollow chamber filled with liquid coolant. Additionally and/or alternatively, the liquid circulation loop 105 may include an embedded pipe structure.

The liquid circulation loop 105 may be shaped to maximize contact with heat generating devices within the server. For instance, the liquid circulation loop 105 may have a square, rectangular, round, or oval cross section. Further, the liquid circulation loop 105 may be located in close proximity to heat generating devices, while still extending around the perimeter of the liquid circulation loop 105. As used herein, being in "close proximity" to the heat generating devices refers to the liquid circulation loop being located less than a threshold distance away from the heat generating devices.

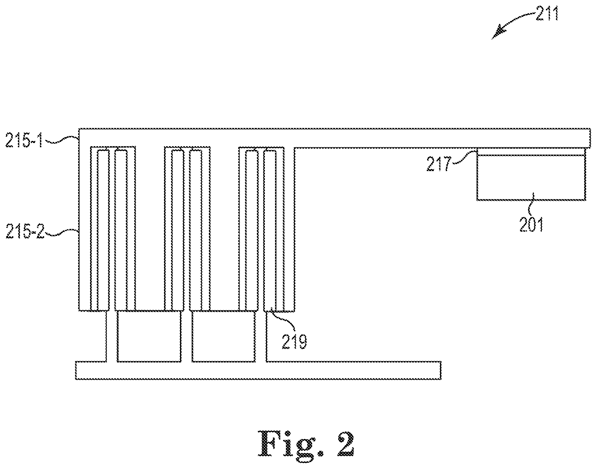

In some examples, the system 100 may include a comb structure 111-1, 111-2 adjacent to the liquid cooling chamber 101 to transfer heat into the liquid circulation loop 105. As used herein, a comb structure refers to a structure having a plurality of extrusion tips, such as aluminum extrusion tip, coupled to a cooling plate. As discussed further in relation to Figure 2, each extrusion tips among the plurality of extrusion tips can extend between a plurality of memory modules in a server. The comb structure 111-1, 111-2, may include a plurality of solid conduction paths to insert between memory modules upon installation of the liquid cooling assembly. As used herein, a solid conduction path may refer to a conduction path that does not have a liquid passageway. Additionally and/or alternatively, the comb structure 111-1, 111-2 may include a closed loop conduction path. As used herein, a closed loop conduction path may refer to a conduction path having a liquid passageway that is sealed (e.g., closed) from liquid coolant exchange external to the comb structure 111-1, 111-2 as opposed to a circulating passage that is open to liquid coolant exchange external to the comb structure 111-1, 111-2.

As used herein, a liquid cooling assembly may refer to a plurality of liquid cooling devices that collectively cool various components within a server. For instance, the liquid cooling assembly may include a liquid cooling chamber 101, the liquid circulation loop 105, and a comb structure 111-1, 111-2. The liquid cooling assembly may be installed in the server system, as well as removed and/or serviced as need be. The liquid cooling assembly may cool various heat generating devices, such as a processor, a plurality of memory modules, and/or a voltage regulator, among other devices.

The liquid cooling assembly may have a plurality of liquid cooling chambers, a plurality of liquid circulation loops, and a plurality of comb structures. For example, the liquid coolant may flow to a first liquid cooling chamber (e.g., liquid cooling chamber 101), through the first liquid circulation loop (e.g., liquid circulation loop 105), to a second liquid cooling chamber (not illustrated in Figure 1), through a second liquid circulation loop (not illustrated in Figure 1), and out through the fluid exit pipe 107. Put another way, the liquid cooling assembly may include a plurality of liquid cooling devices connected in series and/or parallel.

In some examples, the liquid cooling system may be in indirect contact with a voltage regulator. For example, a heat contact pedestal 113 may be coupled to the liquid cooling chamber (e.g., liquid cooling chamber 101-1). As used herein, a heat contact pedestal refers to an extrusion that is at least partially thermally conductive, and contacts a heat generating device. Put another way, a heat contact pedestal 113 may refer to a thermally conductive extrusion that extends from the liquid cooling chamber 101 to a position so as to contact a heat generating device such as a voltage regulator in contact therein. As used herein, a voltage regulator may refer to a circuit that maintains the voltage of a power source within a threshold range. The heat contact pedestal 113 may be in contact with the voltage regulator and may transfer heat from the voltage regulator into the liquid circulation loop 105. In such a manner, the fluid circulation chamber 101 may transfer heat from a processor in contact therein, the comb structure 111-1, 111-2 may transfer heat from a plurality of memory modules, and a heat contact pedestal 113 may transfer heat from a voltage regulator. The liquid circulation loop 105 may transfer heat from the comb structure 111-1, 111-2, the fluid circulation chamber 101, and the heat contact pedestal 113. That is, liquid coolant may pass through the liquid circulation loop 105 and transfer heat from each of the comb structure 111-1, 111-2, the fluid circulation chamber 101, and the heat contact pedestal 113, and direct the flow of the liquid coolant away from the server via the liquid exit pipe 107.

While Figure 1 illustrates the heat contact pedestal 113 coupled to the liquid circulation loop 105, examples are not so limited. For instance, the heat contact pedestal 113 can be removed (e.g., decoupled) from the liquid circulation loop 105. Furthermore, while the heat contact pedestal 113 is illustrated as a generally rectangular structure extending the length of a side of the liquid circulation loop 105, examples are not so limited. For instance, the heat contact pedestal 113 may have shapes than illustrated in Figure 1, and may be larger or smaller than illustrated in Figure 1.

Figure 2 illustrates a diagram of an example of a comb structure 211 for liquid cooling consistent with the present disclosure. The comb structure 211 illustrated in Figure 2 may be analogous to the comb structures 111-1 and 111-2 illustrated in Figure 1. The comb structure 211 may utilize a cooling plate 215-1 that comprises a number of combs 215-2 that may be positioned between memory modules 219.

The comb structure 211 may include a cooling plate 215-1 comprising an interior portion and a comb portion 215-2. The comb portion 215-2 may include extrusion tips (e.g., aluminum extrusion tips, etc.) coupled to the cooling plate 215-1. The cooling plate 215-1 and the comb portion 215-2 could be comprised of one or more of the following: combination of high performance conductive solutions (heat pipes), coolant flowing through the cooling plate 215-1 and comb portion 215-2 and returning to a cooling unit 201, among other cooling techniques. In some examples, liquid (e.g., water, coolant, etc.) may flow through the interior of the comb portions 215-2 to cool the memory modules 219.

Heat from the memory modules 219 may be transferred to the comb portion 215-2 and/or be absorbed by liquid within the comb portion 215-2. The heat from the memory modules 219 may be transferred to the cooling plate 215-1 and flow to the liquid cooling chamber 201. In some examples, a thermal interface junction 217 may be utilized to transfer heat from the cooling plate 215-1 to the liquid cooling chamber 201. In some examples, liquid coolant may flow through the cooling plate 215-1, through the comb portion 215-2 and back to the liquid cooling chamber 201 to remove heat from the memory modules 219.

A liquid circulation loop (e.g., liquid circulation loop 105 illustrated in Figure 1) may be in close proximity (e.g., within a threshold distance) to the comb portions 215-2. The liquid circulation loop may pass a liquid coolant, such as water, and therefore create a temperature differential between warm comb portions 215-2, and cool liquid coolant within the liquid circulation loop. As such, heat may be transferred from the comb portions 215-2, into the liquid circulation loop, and out of the server via the liquid circulation loop.

In some examples, the cooling plate 215-1 may be replaced with a different heat exchange unit such as: a solid conductive material (e.g., aluminum, graphite, copper, etc.), a high performance conductive solution such as a vapor chamber or a coolant chamber, and/or a continually flowing liquid coolant system. In these examples, the liquid cooling chamber 201 may be utilized to cool the cooling plate 215-1 and comb portions 215-2 and/or to remove heat from the memory modules 219.

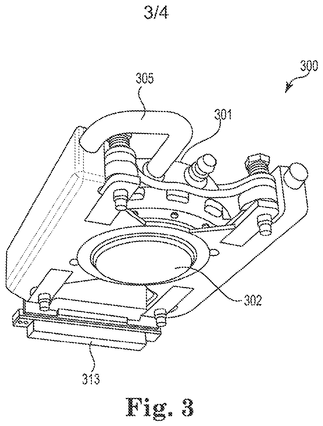

Figure 3 illustrates a diagram of an example system 300 for liquid cooling according to the present disclosure. The system 300 illustrated in Figure 3 may be analogous to the system 100 illustrated in Figure 1. As illustrated in Figure 3, the system 300 may include a liquid cooling chamber 301 coupled to a server device contact pad 302, the liquid cooling chamber 301 to contain a liquid coolant and transfer heat into a liquid circulation loop 305, as discussed in relation to Figure 1. Further, the server device contact pad 302 may be in contact with a heat generating device (e.g., heat generating device 103 discussed in relation to Figure 1) within the server system and may transfer heat to the liquid cooling chamber 301. While Figure 3 illustrates the server device contact pad 302 has having a circular shape, examples are not so limited, and the server device contact pad 302 can have other shapes. Further, the server device contact pad 302 can comprise a thermally conductive material such that heat may be transferred from the heat generating device (e.g., heat generating device 103) to the liquid cooling chamber 301, via the server device contact pad 302. In some examples, the liquid circulation loop 305 may extend around a perimeter of the liquid cooling chamber to direct a flow of the liquid coolant around the liquid cooling chamber, as discussed in relation to Figure 1.

As described in relation to Figure 1, the liquid circulation loop 305 may be coupled to a heat contact pedestal 313 comprised of a thermally conductive material. The heat contact pedestal 313 may transfer heat into the liquid circulation loop 305. For instance, the heat contact pedestal 313 may be in contact with a voltage regulator (not illustrated in Figure 3), and may transfer heat from the voltage regulator to the liquid circulation loop 305.

As illustrated in Figure 3, the system 300 may include a bi-layered cold plate. The bi-layered cold plate may include a liquid cooling layer comprising the liquid cooling chamber 301 and the liquid circulation loop 305, the liquid circulation loop 305 to direct a flow of a liquid coolant around a perimeter of the liquid cooling chamber 301. Further, the bi-layered cold plate may include a thermal interface layer opposite of the liquid cooling layer, the thermal interface layer including a thermally conductive surface, such as the server device contact pad 302, to direct heat from a heat generating device, such as a processor, to the liquid cooling layer (such as the liquid cooling chamber 301). As described in relation to Figure 1, the system 300 may include a comb structure (e.g., comb structure 111-1, 111-2, illustrated in Figure 1, and/or comb structure 211 illustrated in Figure 2) adjacent to the bi-layered cold plate to transfer heat from another heat generating device to the liquid circulation loop 305.

The system 300 may direct heat from a plurality of heat generating devices. For example, a first heat generating device may include a processor, a second heat generating device may include a memory module and/or an array of memory modules, and a third heat generating device may include a voltage regulator. However, examples are not so limited, and other forms of heat generating devices may be included. The liquid circulation loop 305 may be in indirect contact with the voltage regulator, and the liquid circulation loop 305 may direct heat from the voltage regulator away from the server system.

The voltage regulator may be in close proximity to a processor. The voltage regulator may be comprised of inductors and a series of electrical components such as inductors, capacitors, and an integrated circuit. Voltage regulators may be air cooled, however, a heat contact pedestal 313 in accordance with the present disclosure, may provide for improved cooling of a voltage regulator via liquid cooling. As illustrated in Figure 3, the heat contact pedestal 313 may be formed as a stair step and/or appendage. The heat contact pedestal 313 may provide for a compliant connection between the voltage regulator and the liquid circulation loop 305. Compliance can be achieved with gap pad thermal interface materials, for example. In some examples, the heat contact pedestal 313 may have a liquid coolant flowing through it. However, examples are not so limited, and the heat contact pedestal 313 may comprise a solid conductive material.

As described further herein, a heat contact pedestal 313 may be coupled to the bi-layered cold plate, and may be in contact with the voltage regulator. The heat contact pedestal 313 may direct heat from the voltage regulator to the liquid circulation loop 305. Additionally, the comb structure (e.g., comb structure 111-1, 111-2) may include a plurality of solid conductive plates extending between a plurality of memory modules. For example, the memory modules may be Dual In-line Memory Modules (DIMM). Through a solid conduction path (e.g., no liquid running through it), the heat from the memory modules may be transferred into the liquid circulation loop 305.

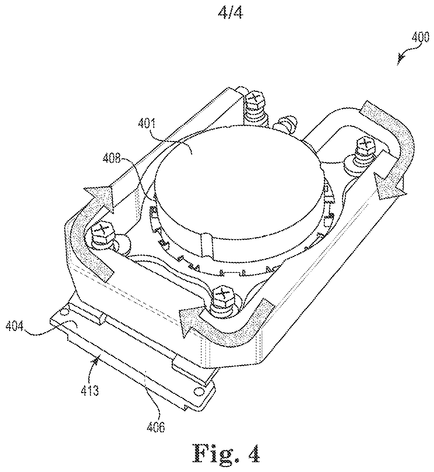

Figure 4 further illustrates a diagram of an example system 400 for liquid cooling according to the present disclosure. The system 400 may be analogous to system 100 illustrated in Figure 1 and system 300 illustrated in Figure 3. In some examples, the heat contact pedestal 413 may have surfaces to both transfer heat and insulate. For example, the heat contact pedestal 413 may include a first surface 406 having a plane parallel to a plane 408 of the liquid cooling chamber 401, the first surface 406 in contact with a voltage regulator, and a second surface 404 having a plane parallel to the plane 408 of the liquid cooling chamber 401 and opposite of the first surface 406, the second surface 404 in contact with a thermal interface material. The thermal interface material can include a gap pad type of material, among other thermal interface materials that can be coupled to the heat contact pedestal 413. The thermal interface material can comprise a material that electrically insulates and thermally transfers.

While examples herein describe a system whereby liquid circulation loop cools a single processor, examples are not so limited. In some examples, the system herein might have a serial flow path. For example, the flow of liquid coolant may proceed from one processor to another processor, then exit. Additionally, in some examples, a pump or other device to accelerate the flow of liquid coolant may be installed within the system (e.g., within system 400 illustrated in Figure 4). For instance, system 400 may have a small pump installed to assist the flow of the liquid coolant.

As used herein, "a" or "a number of" something may refer to one or more such things. For example, "a number of widgets" may refer to one or more widgets. The above specification, examples and data provide a description of the method and applications, and use of the system and method of the present disclosure.

## Claims

1. A system (100), comprising:
a liquid cooling chamber (101) in contact with a heat generating device (103) within a computing device, the liquid cooling chamber (101) to contain a liquid coolant and transfer heat from the heat generating device (103) into a liquid circulation loop (105), the system being **characterised by**:
the liquid circulation loop (105) extending around a perimeter of the liquid cooling chamber (101);
a comb structure (111) adjacent to the liquid cooling chamber (101) to transfer heat into the liquid circulation loop (105); and
a liquid exit pipe (107) coupled to the liquid circulation loop to direct a flow of the liquid coolant around the liquid cooling chamber (101);
a heat contact pedestal (113, 313) coupled to the liquid cooling chamber (101), the heat contact pedestal (113) in contact with a voltage regulator;
wherein the heat generating device (103) is located in a server (109) within the computing device, and further comprising the liquid exit pipe (107) to direct the flow of the liquid coolant to a location different than the liquid cooling chamber (101) and the liquid circulation loop (105) and external to the server (109);
wherein the heat contact pedestal (113, 313) includes:
a first surface having a plane parallel to a plane of the liquid cooling chamber (301), the first surface in contact with the voltage regulator; and
a second surface having a plane parallel to the plane of the liquid cooling chamber (301) and opposite of the first surface, wherein the second surface is in contact with a thermal interface material, wherein the thermal interface material is a gap pad type of material.

2. The system of claim 1, wherein the liquid circulation loop (105) comprises a thermally conductive material.

3. The system of claim 1, wherein:
the liquid cooling chamber (101), the liquid circulation loop (105), and the comb structure (111) comprise a liquid cooling assembly to be installed in the computing device;
the heat generating device (103) includes a processor; and
the comb structure (111) includes a plurality of solid conduction paths to insert between memory modules upon installation of the liquid cooling assembly.

4. A system (300) according to claim 1, whereby the liquid cooling chamber (301) is coupled to a server device contact pad (302); and
the server device contact pad (302) is in contact with the heat generating device within a server system and is to transfer heat to the liquid cooling chamber (301).

5. A system according to claim 1, comprising:
a bi-layered cold plate including:
a liquid cooling layer comprising the liquid cooling chamber (301) and the liquid circulation loop (305); and
a thermal interface layer opposite of the liquid cooling layer, the thermal interface layer including a thermally conductive surface to direct heat from the heat generating device to the liquid cooling layer; and
the comb structure is adjacent to the bi-layered cold plate to transfer heat from a second heat generating device to the liquid circulation loop (305).

6. The system of claim 5, wherein the heat generating device includes a processor and the second heat generating device includes a memory module.

7. The system of claim 5, wherein the heat contact pedestal (313) is coupled to the bi-layered cold plate.

8. The system of claim 5, wherein the comb structure includes a plurality of solid conductive plates extending between a plurality of memory modules.

## Patentansprüche

1. System (100), das Folgendes umfasst:
eine Flüssigkeitskühlkammer (101) in Kontakt mit einer Wärmeerzeugungsvorrichtung (103) innerhalb einer Rechenvorrichtung, wobei die Flüssigkeitskühlkammer (101) ein flüssiges Kühlmittel enthält und Wärme von der Wärmeerzeugungsvorrichtung (103) in eine Flüssigkeitszirkulationsschleife (105) überträgt, wobei das System **gekennzeichnet ist durch** Folgendes:
die Flüssigkeitszirkulationsschleife (105), die sich um einen Umfang der Flüssigkeitskühlkammer (101) herum erstreckt;
eine Kammstruktur (111) angrenzend an die Flüssigkeitskühlkammer (101), um Wärme in die Flüssigkeitszirkulationsschleife (105) zu übertragen; und
ein Flüssigkeitsaustrittsrohr (107), das mit der Flüssigkeitszirkulationsschleife gekoppelt ist, um einen Fluss des Flüssigkeitskühlmittels um die Flüssigkeitskühlkammer (101) herum zu leiten;
einen Wärmekontaktsockel (113, 313), der mit der Flüssigkeitskühlkammer (101) gekoppelt ist, wobei der Wärmekontaktsockel (113) mit einem Spannungsregler in Kontakt steht;
wobei sich die Wärmeerzeugungsvorrichtung (103) in einem Server (109) innerhalb der Rechenvorrichtung befindet, und ferner das Flüssigkeitsaustrittsrohr (107) umfasst, um den Fluss des Flüssigkeitskühlmittels zu einer anderen Stelle als der Flüssigkeitskühlkammer (101) und der Flüssigkeitszirkulationsschleife (105) und außerhalb des Servers (109) zu leiten;
wobei der Wärmekontaktsockel (113, 313) Folgendes beinhaltet:
eine erste Oberfläche, die eine Ebene parallel zu einer Ebene der Flüssigkeitskühlkammer (301) aufweist, wobei die erste Oberfläche mit dem Spannungsregler in Kontakt steht; und
eine zweite Oberfläche, die eine Ebene parallel zu der Ebene der Flüssigkeitskühlkammer (301) und gegenüber der ersten Oberfläche aufweist, wobei die zweite Oberfläche mit einem thermischen Grenzflächenmaterial in Kontakt steht, wobei das thermische Grenzflächenmaterial ein Material vom Spaltkissen-Typ ist.

2. System nach Anspruch 1, wobei die Flüssigkeitszirkulationsschleife (105) ein thermisch leitfähiges Material umfasst.

3. System nach Anspruch 1, wobei:
die Flüssigkeitskühlkammer (101), die Flüssigkeitszirkulationsschleife (105) und die Kammstruktur (111) eine Flüssigkeitskühlanordnung umfassen, die in der Rechenvorrichtung installiert werden soll;
die Wärmeerzeugungsvorrichtung (103) einen Prozessor beinhaltet; und
die Kammstruktur (111) mehrere feste Leitungspfade beinhaltet, die bei Installation der Flüssigkeitskühlanordnung zwischen Speichermodulen eingesetzt werden sollen.

4. System (300) nach Anspruch 1, wodurch die Flüssigkeitskühlkammer (301) mit einer Kontaktinsel (302) der Servervorrichtung gekoppelt ist; und
die Kontaktinsel (302) der Servervorrichtung in Kontakt mit der Wärmeerzeugungsvorrichtung innerhalb eines Serversystems steht und Wärme an die Flüssigkeitskühlkammer (301) übertragen soll.

5. Verfahren nach Anspruch 1, das Folgendes umfasst:
eine zweischichtige Kaltplatte, die Folgendes beinhaltet:
eine Flüssigkeitskühlschicht, die die Flüssigkeitskühlkammer (301) und die Flüssigkeitszirkulationsschleife (305) umfasst; und
eine thermische Grenzflächenschicht gegenüber der Flüssigkeitskühlschicht, wobei die thermische Grenzflächenschicht eine thermisch leitfähige Oberfläche beinhaltet, um Wärme von der Wärmeerzeugungsvorrichtung zu der Flüssigkeitskühlschicht zu leiten; und
die Kammstruktur angrenzend an die zweischichtige Kaltplatte ist, um Wärme von einer zweiten Wärmeerzeugungsvorrichtung an die Flüssigkeitszirkulationsschleife (305) zu übertragen.

6. System nach Anspruch 5, wobei die Wärmeerzeugungsvorrichtung einen Prozessor beinhaltet und die zweite Wärmeerzeugungsvorrichtung ein Speichermodul beinhaltet.

7. System nach Anspruch 5, wobei der Wärmekontaktsockel (313) mit der zweischichtigen Kaltplatte gekoppelt ist.

8. System nach Anspruch 5, wobei die Kammstruktur mehrere feste leitfähige Platten beinhaltet, die sich zwischen mehreren Speichermodulen erstrecken.

## Revendications

1. Système (100) comprenant :
une chambre de refroidissement par liquide (101) en contact avec un dispositif de génération de chaleur (103) à l'intérieur d'un dispositif informatique, la chambre de refroidissement par liquide (101) pouvant contenir un liquide de refroidissement et transférer la chaleur provenant du dispositif de génération de chaleur (103) dans une boucle de circulation de liquide (105), le système étant **caractérisé par** :
l'extension de la boucle de circulation de liquide (105) autour d'un périmètre de la chambre de refroidissement par liquide (101) ;
une structure en peigne (111) adjacente à la chambre de refroidissement par liquide (101) pour transférer la chaleur dans la boucle de circulation de liquide (105) ; et
un tuyau de sortie de liquide (107) accouplé à la boucle de circulation de liquide pour diriger un écoulement du liquide de refroidissement autour de la chambre de refroidissement par liquide (101) ;
un socle de contact thermique (113, 313) accouplé à la chambre de refroidissement par liquide (101), le socle de contact thermique (113) étant en contact avec un régulateur de tension ;
dans lequel le dispositif de génération de chaleur (103) est situé dans un serveur (109) à l'intérieur du dispositif informatique, et comprenant en outre le tuyau de sortie de liquide (107) pour diriger l'écoulement du liquide de refroidissement vers un emplacement différent de la chambre de refroidissement par liquide (101) et de la boucle de circulation de liquide (105) et externe au serveur (109) ;
dans lequel le socle de contact thermique (113, 313) comporte :
une première surface présentant un plan parallèle à un plan de la chambre de refroidissement par liquide (301), la première surface étant en contact avec le régulateur de tension ; et
une seconde surface présentant un plan parallèle au plan de la chambre de refroidissement par liquide (301) et opposée à la première surface, la seconde surface étant en contact avec un matériau d'interface thermique, dans lequel le matériau d'interface thermique est un matériau du type à tampon d'espacement.

2. Système selon la revendication 1, dans lequel la boucle de circulation de liquide (105) comprend un matériau thermiquement conducteur.

3. Système selon la revendication 1, dans lequel :
la chambre de refroidissement par liquide (101), la boucle de circulation de liquide (105) et la structure en peigne (111) comprennent un ensemble de refroidissement par liquide à installer dans le dispositif informatique ;
le dispositif de génération de chaleur (103) comporte un processeur ; et
la structure en peigne (111) comporte une pluralité de chemins de conduction solides à insérer entre les modules de mémoire lors de l'installation de l'ensemble de refroidissement par liquide.

4. Système (300) selon la revendication 1, dans lequel la chambre de refroidissement par liquide (301) est accouplée à un tampon de contact de dispositif serveur (302) ; et
le tampon de contact de dispositif serveur (302) est en contact avec le dispositif de génération de chaleur dans un système serveur et doit transférer la chaleur vers la chambre de refroidissement par liquide (301).

5. Procédé selon la revendication 1, comprenant :
une plaque froide à deux couches comportant :
une couche de refroidissement par liquide comprenant la chambre de refroidissement par liquide (301) et la boucle de circulation de liquide (305) ; et
une couche d'interface thermique opposée à la couche de refroidissement par liquide, la couche d'interface thermique comportant une surface thermoconductrice pour diriger la chaleur du dispositif de génération de chaleur vers la couche de refroidissement par liquide ; et
la structure en peigne est adjacente à la plaque froide à deux couches pour transférer la chaleur d'un second dispositif de génération de chaleur à la boucle de circulation de liquide (305).

6. Système selon la revendication 5, dans lequel le dispositif de génération de chaleur comporte un processeur et le second dispositif de génération de chaleur comporte un module de mémoire.

7. Système selon la revendication 5, dans lequel le socle de contact thermique (313) est accouplé à la plaque froide à deux couches.

8. Système selon la revendication 5, dans lequel la structure en peigne comporte une pluralité de plaques conductrices solides s'étendant entre une pluralité de modules de mémoire.
